# EUROPÄISCHE PATENTSCHRIFT

(11) **EP 1 701 395 B1**
(45) Veröffentlichungstag und Bekanntmachung des Hinweises auf die Patenterteilung: **12.09.2012**
(21) Anmeldenummer: 05005386.7
(22) Anmeldetag: 11.03.2005
(51) Int. Cl.: H01L 51/52

(54) **Transparentes lichtemittierendes Bauelement**
Transparent light emitting element
Elément transparent émetteur de lumière

(43) Veröffentlichungstag der Anmeldung: 13.09.2006
(73) Patentinhaber: Novaled AG, 01307 Dresden (DE)
(72) Erfinder: Birnstock, Jan, Dr., 01187 Dresden (DE); Murano, Sven, Dr., 01309 Dresden (DE); Vehse, Martin, Dr., 27777 Ganderkesee (DE)
(74) Vertreter: Bittner, Thomas L.

(56) Entgegenhaltungen:
- EP-A- 1 076 368
- EP-A- 1 100 129
- DE-A1- 10 215 210
- DE-A1- 10 228 939
- US-A1- 2003 184 219
- US-B1- 6 356 032

## Beschreibung

Die Erfindung bezieht sich auf ein transparentes lichtemittierendes Bauelement, insbesondere eine organische Leuchtdiode, mit einer transparenten Schichtanordnung, bei der auf einem Substrat in einem Stapel flächige Elektroden und ein zwischen den flächigen Elektroden angeordneter organischer Bereich, welcher eine lichtemittierende Schicht umfasst, aus einem oder mehreren organischen Materialien gebildet sind.

### Stand der Technik

Organische Leuchtdioden (OLED) gewinnen in den letzten Jahren verstärkt Aufmerksamkeit aufgrund ihres hohen Potentials für Anwendungen im Bereich der Beleuchtung und der Anzeige von Informationen. Hierbei sind eine Vielzahl von Aspekten organischer Leuchtdioden von Bedeutung, unter anderem ihr Potential für hohe Leistungseffizienzen, ihre Verwendbarkeit auf flexiblen Substraten, ihre Steuerbarkeit der Farbemission sowie die Möglichkeit, transparente OLEDs als Beleuchtungselemente oder Anzeigeelemente zu verwenden. Insbesondere als Flächenstrahler sind OLEDs grundsätzlich verschieden, zu bekannten Beleuchtungstechniken, beispielsweise anorganischen Leuchtdioden, Glühlampen oder Leuchtstoffröhren. Sie stellen eine völlig neue Technik dar, welche die Anwendungsvielfalt erweitern kann.

Eine Realisation von Fensterscheiben basierend auf transparenten. OLEDs wäre eine solche Anwendung, wobei als Maß für die Transparenz der OLED üblicherweise der Transmissionsgrad für auf die OLED einfallendes Licht herangezogen wird. Derartige Fensterscheiben würden es ermöglichen, architektonisch Beleuchtungselemente vorzusehen, welche zum einen das Tageslicht ausnutzen, andererseits aber auch selbständig leuchten können. Ebenfalls sind transparente Displays interessant, die zum Beispiel in Frontscheiben von Verkehrsmitteln eingebaut werden und den Führer des Verkehrsmittels mit Informationen versorgen können. Ferner besteht der Wunsch, vor Objekte, auf die die Sicht frei, bleiben soll, transparente Beleuchtungs- oder Anzeigeelemente zu setzen. So kann zum Beispiel im Fahrzeug vor dem Geschwindigkeitsmesser ein transparentes Display plaziert werden, das den Fahrer beispielsweise vor einer angezogenen Handbremse warnt, ansonsten aber ausgeschaltet ist.

Bei einer solchen Verwendung transparenter OLEDs geht jedoch ein Anteil von etwa 50% des emittierten Lichtes verloren, da üblicherweise das im lichtemittierenden organischen Bereich der OLED erzeugte Licht durch die beiden OLED-Außenflächen auf der Ober- und der Unterseite näherungsweise zu gleichen Teilen emittiert wird. Hierdurch werden die Effektivität des Beleuchtungselements oder die Helligkeit des Displays drastisch reduziert, wodurch eine mögliche kommerzielle Anwendung erschwert ist.

Transparente OLEDs sind als solche bereits bekannt, beruhend auf der Verwendung von zwei transparenten Elektroden, die beispielsweise aus leitfähigen Gläsern wie ITO oder dünnen Metallen oder Kombinationen hiervon bestehen können. Im Gegensatz zu transparenten OLEDs verfügen klassische OLEDs über genau eine transparente Elektrode, während die zweite Elektrode aus einem reflektierenden Metall besteht, wodurch das Licht ausschließlich durch die transparente Elektrode emittiert wird.

Es gibt Bernühungen, transparente OLEDs mit sogenannten schaltbaren Spiegeln zu verbinden. Hierbei wird zusammen mit der OLED der Spiegel eingeschaltet und das gesamte Licht der OLED in dieselbe Richtung gesandt. Diese Variante ist jedoch sehr aufwendig und kostenintensiv.

Es gibt auch noch einen weiteren Ansatz, nach dem semitransparente organische Leuchtdioden gebaut werden, die eine hochtransparente und eine, bedingt durch hohe Absorptionsverluste, weniger transparente Elektrode haben. Eine größere Lichtmenge wird hierbei durch die hochtransparente Elektrode abgestrahlt. Allerdings wird bei diesem Ansatz die ungleiche Lichtabstrahlung lediglich durch Absorption in der weniger transparenten Elektrode erkauft, das heißt eine Verringerung der Effizienz der OLED findet statt. Darüber hinaus leidet der Gesamttransmissionsgrad der OLED unter der niedrigeren Transparenz der einen Elektrode. Ein vereinfachtes Rechenbeispiel soll das verdeutlichen: Unter der Annahme, dass die organischen Schichten einen Transmissionsgrad von 1 aufweisen, eine Elektrode einen Transmissionsgrad von 0.6 und die zweite einen Transmissionsgrad von 0.9, hat die OLED in erster Näherung einen Transmissionsgrad von knapp über 50%. Von allen Photonen, die das Bauelement verlassen, werden zwei Fünftel durch die eine Elektrode und drei Fünftel durch die andere Elektrode emittiert. 25% der Photonen, die auch das Bauelement verlassen hätten, werden in den Elektroden absorbiert. Soll nun statt einem Verhältnis der abgestrahlten Lichtintensitäten auf den beiden Seiten des Bauelementes von 2:3 ein Verhältnis von 1:4 realisiert werden, müssten schon Elektroden mit einem Transmissionsvermögen von 0.9 und 0.22 genutzt werden. Der Transmissionsgrad des Bauelementes betrüge dann nur noch 20% und 44% der Photonen, die eigentlich das Bauelement verlassen würden, werden in den Elektroden absorbiert. Der Transmissionsgrad von 90% für die höher transparente Elektrode wurde in dieser Rechnung verwendet, da dies bereits einen sehr hohen Wert für transparente und leitfähige Elektroden darstellt. Unter besonders idealen Bedingungen sind auch 95% erreichbar, was aber an der Rechnung nichts grundlegend ändert.

In dem Dokument EP 1 076 368 A2 wird eine organische lichtemittierende Diode beschrieben, bei der eine transparente Schichtanordnung mit einem Substrat, zwei flächigen Elektroden sowie einem hierzwischen angeordneten organischen Bereich gebildet ist. Der organische Bereich umfaßt eine lichtemittierende Schicht aus mehreren organischen Materialien. In einem Beispiel C ist eine Kathode aus Silber mit einer Dicke von 20nm gebildet. Eine Anode ist aus ITO. Auf der Metallschicht ist eine Oxidschicht aus MgO mit einer Dicke von 56nm angeordnet.

Das Dokument 6,356,032 B1 offenbart ein organisches elektrolumineszentes Bauelement, bei dem eine Anode aus einem transparenten leitenden Material ist, beispielsweise ITO. Eine Kathode ist aus einem metallischen Material, zum Beispiel Al. Weiterhin sind eine Löcher-Injektionsschicht, eine Löcher-Transportschicht, eine Elektronen-Transportschicht und eine Elektronen-Injektionsschicht zwischen der Anode und der Kathode angeordnet.

Im Dokument US 2003 / 0184219 A1 ist ein elektrolumineszentes Bauelement offenbart, welches auf einem flexiblen Substrat aufgebracht ist. Eine Oberfläche des flexiblen Substrats ist mit einer mehrschichtigen Barriere beschichtet, die wenigstens eine Unterschicht aus einem im wesentlichen transparenten organischen Polymer und wenigstens eine weitere Unterschicht aus einem im wesentlichen transparenten anorganischen Material umfaßt.

In dem Dokument EP 1 100 129 A2 ist ein Substrat für ein lichtemittierendes Bauteil beschrieben, welches einen elektrisch leitenden und transparenten Film umfaßt, der in Kontakt mit einer Oberfläche eines Elementes mit einem niedrigen Brechungsindex ist, wobei der Brechungsindex größer als 1 und kleiner als 1,3 ist.

Weiterhin ist aus dem Dokument DE 102 15 210 A1 ein lichtemittierendes transparentes Bauelement mit einer transparenten Schichtanordnung bekannt. Die transparente Schichtanordnung umfaßt ein transparentes Substrat, auf dem in einem Stapel flächige Elektroden und ein zwischen den flächigen Elektroden angeordneter organischer Bereich gebildet sind, der eine lichtemittierende Schicht umfaßt. Der Transmissionsgrad der transparenten Schichtanordnung ist größer als 50 Prozent. In dem organischen Bereich sind mehrere dotierte Ladungsträger-Transportschichten vorgesehen.

### Die Erfindung

Aufgabe der Erfindung ist es, ein transparentes lichtemittierendes Bauelement, insbesondere eine organische Leuchtdiode, zu schaffen, mit dem die Anwendungsmöglichkeiten für transparente lichtemittierende Bauelemente erweitert werden.

Diese Aufgabe wird erfindungsgemäß durch ein transparentes lichtemittierendes Bauelement nach dem unabhängigen Anspruch 1 gelöst. Vorteilhafte Ausgestaltungen der Erfindung sind Gegenstand von abhängigen Unteransprüchen.

In dem organischen Bereich sind eine oder mehrere dotierte Ladungsträger-Transportschichten gebildet.

Mit der Erfindung ist ein transparentes lichtemittierendes Bauelement, insbesondere eine organische Leuchtdiode (OLED), zur Verfügung gestellt, welches eine bevorzugte Emission des Lichtes durch eine der beiden Elektroden mit einer hohen Gesamttransparenz des Bauelementes in zumindest einer Einfallsnchtung vereint. Ein solches Bauelement kann insbesondere als ein Beleuchtungselement Verwendung finden, welches Gebäudeinnenräume zur Außenwelt abgrenzt, beispielsweise in Form einer Fensterscheibe. Diese Bauelemente können dann während Tageslichteinfall das, Gebäudeinnere mit Licht versorgen, ohne dass sich das lichtemittierende Bauelement in einem Betriebszustand befindet. Bei Abnahme des Tageslichtes kann das Bauelement dann angeschaltet werden, wobei das erzeugte Licht bevorzugt in das Gebäudeinnere emittiert wird, wodurch die Ausnutzung der Leuchtleistung erheblich verbessert wird. Darüber hinaus ist die Verwendung eines entsprechenden Bauelementes auch in anderen Anwendungsbereichen möglich, beispielsweise einzeln oder als Kombination von mehreren lichtemittierenden Bauelementen in einem aktiven oder einem, passiven Anzeigenelement oder einem Display oder auch in einer Beleuchtungsvorrichtung, beispielsweise in Fahrzeugen oder als Raumbelenchtung.

Gegenüber dem Stand der Technik hat die Erfindung weiterhin den Vorteil, dass nicht ein Großteil des im lichtemittierenden organischen Bereich erzeugten Lichtes aufgrund von Absorption verlorengeht.

In bevorzugten Ausführungsformen kann bei der Elektrode die Oxidschicht aus dem elektrisch leitfähigen Oxidmaterial eine Dicke von wenigstens 15nm, bevorzugt von wenigstens 25nm, vorzugsweise von wenigstens 40nm oder weiter bevorzugt von wenigstens 60nm aufweisen. Höhere Schichtdicken lassen sich zuverlässiger herstellen und erleichtern die Stromzuführung.

Zweckmäßige Ausgestaltungen der Erfindung sehen vor, dass bei der anderen Elektrode die Metallschicht eine Dicke von weniger als 30nm, bevorzugt von weniger als 20nm oder vorzugsweise von weniger als 10nm aufweisen. Mit abnehmender Schichtdicke nimmt der Transmissionsgrad zu.

### Ausführungsbeispiele

Die Erfindung wird im folgenden anhand von Ausführungsbeispielen unter Bezugnahme auf die Figuren einer Zeichnung näher erläutert. Hierbei zeigen:
- Fig. 1: eine schematische Darstellung eines transparenten lichtemittierenden Bauelementes mit einer transparenten Schichtanordnung;
- Fig. 2: eine graphische Darstellung der Leuchtdichte in Abhängigkeit von der Spannung für ein transparentes lichtemittierendes Bauelement nach einem Ausführungsbeispiel;
- Fig. 3: eine graphische Darstellung der Stromeffizienz in Abhängigkeit von der Spannung für das transparente lichtemittierende Bauelement nach dem Ausführungsbeispiel; und
- Fig. 4: eine graphische Darstellung des Transmissionsgrades in Abhängigkeit von der Wellenlänge für das transparente lichtemittierende Bauelement nach dem Ausftihrungsbeispiel.

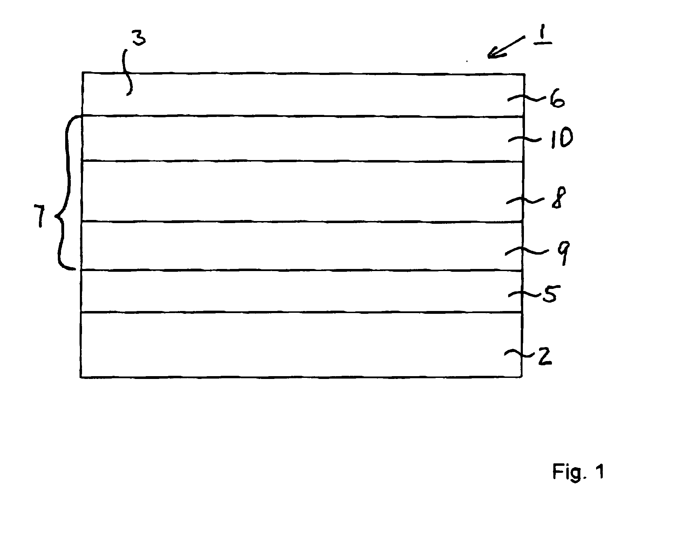

Fig. 1 zeigt eine schematische Darstellung eines transparenten lichtemittierenden Bauelementes in Form einer organischen Leuchtdiode (OLED) mit einer transparenten Schichtanordnung 1, bei der auf einem transparenten Substrat 2 in einem Stapel 3 flächige Elektroden 5, 6 und ein zwischen den flächigen Elektroden 5, 6 angeordneter organischer Bereich 7, welcher eine lichtemittierende Schicht 8 umfasst, aus einem oder mehreren organischen Materialien gebildet sind. Der organische Bereich 7 umfasst weiterhin Ladungsträger-Transportschichten 9, 10, die mit einer Dotierung versehen sein können oder nicht. Darüber hinaus kann der organische Bereich 7 weitere Schichten (nicht dargestellt) umfassen, wie sie für organische Leuchtdioden als solche bekannt sind, beispielsweise Blockschichten. Die lichtemittierende Schicht 8 kann ein- oder mehrschichtig ausgeführt sein.

Mittels der Dotierung der Ladungsträger-Transportschichten 9, 10 ist zum einen der Ladungsträgertransport nicht von der Schichtdicke abhängig, was eine freie Wahl der verwendeten Schichtdicken erlaubt und eine Optimierung des Schichtaufbaus auf das gewünschte Auskopplungsverhalten ermöglicht. Andererseits wird mit der Dotierung der Ladungsträger-Transportschichten 9, 10 die Begrenzung der verwendbaren Materialien für die Elektroden 5, 6 aufgehoben, wie sie bei OLEDs mit undotierten Transportschichten besteht. Eine Anpassung der Austrittsarbeit der Elektrode an die Energieniveaus der angrenzenden organischen Schicht ist aufgrund der Dotierung nicht notwendig, so dass eine freie Wahl des Elektrodenmaterials auf beiden Seiten der OLED möglich ist.

Das in Fig. 1 dargestellte lichtemittierende Bauelement kann als inverlierte oder als nichtinvertierte Struktur ausgeführt sein, wodurch festgelegt ist, welche der beiden flächigen Elektroden 5, 6 eine Anode oder eine Kathode ist.

Eine der flächigen Elektroden 5, 6 umfasst eine Metallschicht mit einer Dicke von weniger als 40nm und die andere der flächigen Elektroden 5, 6, welche in der transparenten Schichtanordnung 1 der Elektrode gegenüberliegend angeordnet ist, weist eine Oxidschicht aus einem elektrisch leitfähigen Oxidmaterial mit einer Dicke von wenigstens 10nm auf. Für eine auf einer Seite der transparenten Schichtanordnung 1 austretende Lichtemission und eine auf einer gegenüberliegenden Seite der transparenten Schichtanordnung 1 austretende Lichtemission ist ein Intensitätsverhältnis von mindestens 2:1 gebildet. Ein Transmissionsgrad der transparenten Schichtanordnung 1 für wenigstens einen Wellenlängenteilbereich im sichtbaren Spektralbereich ist für zumindest eine Einfallsrichtung größer als 50%.

zur Realisierung einer organischen Leuchtdiode, wie sie in Fig. 1 schematisch dargestellt ist, mit bevorzugter Lichtemission auf einer Seite des Bauelementes bei gleichzeitig hohem Gesamttransmissionsgrad ist es notwendig, beide Elektroden 5, 6 als transparente oder semitransparente Kontakte zu gestalten. Hierfür können Elektroden aus transparenten leitenden Gläsern, wie zum Beispiel Indium-Zinn-Oxid (ITO), Indium-Zink-Oxid (IZO), dünnen Metallen wie Aluminium, Gold, Silber, Calcium, Magnesium, Chrom, Ytterbium, Molybdän, Tantal, oder dergleichen sowie aus kombinierten Mehrschichtabfolgen hiervon gebildet werden, beispielsweise ITO-Metall-ITO-Stapel. Die zwischen den Elektroden 5, 6 entstehenden Mikrokavitäten, insbesondere hinsichtlich des erzeugten Lichtes und dessen Ausbreitung, werden optimiert, so dass eine Lichtemission durch die gewünschte Elektrode optimiert ist, wohingegen eine Lichtemission durch die gegenüberliegende Elektrode verringert wird, wie dieses unten anhand von Ausführungsbeispielen näher erläutert wird.

Die im folgenden vorgestellten Ausführungsbeispiele zur weiteren Erläuterung der Erfindung wurden zunächst mit Hilfe einer Computersimulation berechnet, dann wurde an ausgewählten Beispielen die Übereinstimmung der theoretisch bestimmten Ergebnisse mit tatsächlich hergestellten und vermessenen OLEDs überprüft und bestätigt.

Es kann vorgesehen sein, die Auskoppelung des Lichtes durch die gewünschte der Elektroden 5, 6 mittels geeigneter Maßnahmen weiter zu optimieren, beispielsweise mittels Verwendung einer Auskoppelfolie, einer Entspiegelungsschicht, oder dergleichen., wodurch zum Einen das Verhältnis der Emissionen durch Vorder- und Rückseite weiter vergrößert wird, zum anderen gegebenenfalls auch die Gesamttransparenz des Bauelementes verbessert wird.

Die Effizienz des Bauelementes lässt sich ferner verbessern, indem zwischen dem transparenten Substrat und der dem transparenten Substrat zugewandten flächigen Elektrode eine weitere Schicht (nicht dargestellt) mit einem Brechungsindex kleiner als 1.4 eingebracht wird. Mittels dieser Schicht wird die Auskopplung des emittierten Lichtes aus dem organischen Bereich in das Substrat unterstützt und gegebenenfalls auch das Abstrahlverhältnis erhöht.

Bei einem Ausführungsbeispiel sind eine ITO-Schicht auf einem. Glassubstrat mit einer Dicke von 60nm als transparente und eine dünne Metallschicht als semitransparente Gegenelektrode vorgesehen. Damit die Metallschicht semitransparent ist, muss diese ausreichend dünn gewählt werden. Dies ist jedoch nicht bei jedem Metall möglich ohne dass die Leitfähigkeit der Schicht zu stark verringert wird. Beispielsweise muss bei Aluminiumschichten die Schichtdicke des Metalls kleiner als 4nm sein, damit eine Gesamttrausparenz der Schichtanordnung von 50% erreicht wird. Eine solch dünne Schicht würde jedoch nicht ausreichen um das Bauelement über diese Elektrode mit dem nötigen Strom zu versorgen.

Um den Gesamttransmissionsgrad des Bauelementes trotz dickerer Aluminiumschicht auf 50% zu halten, kann eine zusätzliche Schicht mit einem Brechungsindex größer als 1.3 auf der von der OLED abgewandten Seite aufgebracht werden. Diese zusätzliche Schicht dient als eine Art Auskoppelschicht oder Entspiegelungsschicht und reduziert gleichzeitig die Absorption der Lichtrnode in der Metallschicht. Bei der zusätzlichen Schicht kann es sich um eine im sichtbaren Spektralbereich transparente organische Schicht handeln, wie zum Beispiel Meo-TPD (NN,NNI-Tetrakis(4-methoxyphenyl)-benzidin,e) oder Spiro-TAD (2,2',7,7'-Tetrakis-(N,N-diphenylamino)-9,9'-spirobifluoren), welche im sichtbaren Spektralbereich einen Brechungsindex von etwa 1.7 aufweisen. Mit Hilfe einer 80nm dicken Meo-TPD-Schich.t kann eine Al-Dicke von 8nm verwendet werden.. um einen Gesaznttransmissivnsgrad von 50% zu erzielen. Dieser Effekt wird umso stärker je höher der Brechungsindex des verwendeten Materials ist.

Eine besonders vorteilhafte Ausführung der zusätzlichen Schicht ist gebildet, wenn diese nicht nur im sichtbaren Spektralbereich transparent, sondern auch noch elektrisch leitfähig ist, wie das bei vielen Metalloxiden, zum Beispiel ITO, IZO, ZnO, TiO2, der Fall, ist. Dies hat den Vorteil, dass sich die elektrische Leitfähigkeit jetzt aus der Metallschicht und der zusätzlichen Schicht ergibt. Für den bereits erwähnten Fall der 5nm dicken Al-Schicht in Kombination mit einer 40nm dicken ITO-Schicht hieße dies, dass diese Schicht eine ausreichend hohe Leitfähigkeit aufweist. Unter einer ausreichend hohen Leitfähigkeit wird ein Flächenwiderstand der Elektrode von weniger als 200 Ohm/square, bevorzugt weniger als 30 Ohm/square verstanden. Die Gesamttransmission der OLED liegt aufgrund des hohen Brechungsindexes von ITO, welcher im sichtbaren Spektralbereich 1.8 bis 2 beträgt, sogar bei 70%. Weiterhin besteht hierbei die Möglichkeit, mittels Variation der Schichtdicken von ITO und A1 sowohl den Gesamttransmissionsgrad, das Abstrahlverhältnis und die Effizienz; des Bauelementes zu variieren. Bei einer transparenten roten OLED mit einem Emissionspeak bei 630nm führt beispielsweise eine Erhöhung der Al-Dicke von 5nm auf 8nm zu einem Rückgang der Gesamttransmission von 70% auf 55%. Das Abstrahlverhältnis, gemessen anhand der Intensität des abgestrahlten Lichtes auf der Oberseite und der Substratseite des Bauelementes, ändert sich jedoch von 1:5 auf 1:10 bei einer gleichzeitigen Effizienzsteigerung des Bauelementes um 40% auf der Substratseite.

Mittels Aufbringen einer Auskopplungsschicht auf der von dem organischen Bereich abgewandten Substratseite kann die Effizienz und damit auch das Abstrahlverhältnis, je nach WirKungsgrad der Auskopplungsschicht, noch mal deutlich verbessert werden. Beispielsweise können mit einer einfachen Streufolie Verbesserungen von 40% erzielt werden.

Als besonders vorteilhaft erweist sich eine Dotierung der Ladungsträger-Transportschichten 9, 10 (vgl. Fig. 1), da dann beliebige Metalle als Elektrode 5, 6 gewählt werden können, ohne dass auf die Austrittsarbeit des jeweiligen Metalls Rücksicht genommen werden muss. Somit können gezielt Metalle verwendet werden, die bei der notwendigen. Transparenz noch eine ausreichend gute Leitfähigkeit der Schicht aufwcisen, So kann anstelle der Al-Elektrode eine Ag-Elektrode verwendet werden. Mit einer dünnen Ag-Schicht von 15nm, die eine ausreichende elektrische Leitfähigkeit für den Betrieb der OLED aufweist, kann ein Gesamttransmissionsgrad des Bauelementes von über 50% erzielt werden. Werden die Schichten im organischen Bereich der OLED auf diese Elektrodenkonfiguration abgestimmt, so lässt sich beispielsweise für eine rote OLED ein Abstrahlverhältnis von bis zu 1:10 (Oberseite : Substratseite) realisieren.

Auch hier kann, wie oben beschrieben, mittels Aufbringen einer zusätzlichen Schicht auf die Ag-Elektrode die Gesamttransmission der OLED verbessert werden. Mit Hilfe einer 40nm dicken Meo-TPD-Schicht kann diese von 50% auf 70% bis 80% erhöht werden. Jedoch wird beispielsweise bei einer roten OLED auch das Abstrahlverhältnis von 1:10 auf 1:6 verändert.

Auch hierbei lassen sich mit Hilfe einer geringen Veränderung der Ag-Schichtdicke der Gesamttransmissionsgrad, das Abstrahlverhältnis und die EfFtzienz der OLED variieren. Beispielsweise wird bei einer Änderung der Ag-Dicke von 15nm auf 25nm und einer Abstimmung der Schichten im organischen Bereich des Bauelementes auf die Elektrodenkonfiguration mit einer 40nm dicken zusätzlichen Schicht der Gesamttransmissionsgrad des Bauelementes von 70% bis 80% auf 50% reduziert. Das Abstrahlverhältnis hingegen wird von 1:6 auf 1:14 bei einer Effizienzsteigerung von 40% auf der Substratseite verbessert.

Wie bei der Al-Elelctrode kann auch hierbei mit anderen zusätzlichen Schichten, die einen höheren Brechungsindex als Meo-TPD aufweisen, gearbeitet werden, und die Effizienz und das Abstrahlverhältnis der OLED können gezielt modifiziert werden.

Neben der Kombination von Metallschicht und ITO-Zusatzschicht ist eine weitere Variante, den Kontakt durch eine ITO/Metall/ITO (IMI) Schichtfolge zu ersetzen. Mittels Wahl der Schichtdicken können so extrem transparente Elektroden hergestellt werden, die trotzdem ein ausreichend gutes Reflexionsvermögen besitzen, um zu einer gerichteten Abstrahlung zu führen. Zum Beispiel wurde mit einer 60nm ITO-Grundelektrode auf dem Glassubstrat und einer IMI-Elektmde aus 5nm ITO/ 5nm Ag/ 135nm ITO ein Gesamttransmissionsgrad der OLED von 80% bis 90% im sichtbaren Spektralbereich erreicht. Das Abstrahlverhältnis einer roten OLED beträgt hierbei 1:5 (Oberseite : Substratseite). Wird die Dicke der Ag-Schicht auf 10nm erhöht, sinkt der Gesamttransmissionsgrad der OLED auf 60% bis 80%, das Abstrahlungsverhältnis steigt aber auf 1:9 an, und die Effizienz der OLED in die bevorzugte Abstrahlrichtung erhöht sich um 26%.

Nach dem Prinzip des semitransparenten Metallkontaktes mit Zusatzschicht wurde bei einer roten OLED mit einem 15nm dicken Au-Kontakt und einer 50nm dicken Meo-TPD-Zusatzschicht bei einem Abstrahlverhältnis von 3:1 ein Gesamtransmissionsgrad des Bauelementes von 90% im roten Spektralbereich erreicht. Da das Transmissionsband wesentlich schmaler ist als der gesamte sichtbare Spektralbereich, kann mittels geeigneter Wahl der Kontaktschicht- und der Zusatzschichtdicke die maximale Transmission an eine bestimmte Stelle des sichtbaren Spektrums verschoben werden, und das transparente lichtemittierende Bauelement dient somit als eine Art Farbfilter. Beispielsweise kann das Maximum der Transmission in den grünen Spektralbereich verschoben werden, wo die Empfindlichkeit des menschlichen Auges am höchsten ist. Die OLED ist jedoch rot oder blau und hat damit eine bessere Reflexion an der Elektrode und folglich eine stärker gerichtete Abstrahlcharakteristik.

Bei einer 60nm dicken ITO-Elektrode auf dem Glassubstrat und einer 15nm Au-Gegenelektrode mit einer 160nm dicken Meo-TPD-Zusatzschicht erreicht eine blaue, hinsichtlich der Schichtdicken optimierte OLED mit einem Emissionspeak bei 450nm einen Gesamttransnüssionsgrad von 60% im Spektralbereich zwischen 420 und 600nm. Diese OLED hat ein Abstrahhmgsverhältnis von 1:5 (Oberseite : Substratseite). Mittels bloßer Reduzierung der Zusatzschicht steigt der Transmissionsgrad im grünen Spektralbereich auf 80% an und sinkt im blauen Spektralbereich auf unter 60% ab. Das Abstrahlungsverhältnis steigt auf 1:6, und die Effizienz der OLED in die bevorzugte Abstrahlungsrichtung steigt um 27%.

Dieser Effekt wird noch verstärkt, wenn die Meo-TPD-Schicht durch eine Schicht mit höherem Brechungsindex ersetzt wird, zum Beispiel eine Schicht aus TiO2 oder ZnS. Bei einer 180nm dicken TiO2-Schicht steigt der Transmissionsgrad im grünen Spektralbereich auf 80% an und sinkt im blauen und roten Spektralbereich auf unter 50% ab. Auch hier beträgt das Abstrahlungsverhältnis 1:6.

Wie bereits erläutert wird mittels Dotierung der Ladungsträger-Transportschichten eine weitreichende Freiheit bei der Wahl des Materials für die Elektroden erreicht. Dies bedeutet, dass es auch möglich ist, die beiden Elektroden miteinander zu vertauschen. Zum Beispiel kann eine 15nm dicke Ag-Schicht auf das Glassubstrat aufgebracht werden, und nach dem Auf bringen der organischen Schichten wird eine 80nm dicke ITO-Schicht als Elektrode auf die OLED aufgesputtert. Der Vorteil dieser Bauform besteht darin, dass das Glassubstrat aufgrund seines Brechungsindexes von 1.45 im sichtbaren Spektralbereich bereits die oben beschriebene Funktion der Zusatzschicht übernimmt. Der Gesamttransmissionsgrad der OLED liegt dadurch bereits bei 75%, das Abstrahlverhältnis in beide Richtungen ist jedoch nahezu identisch. Mittels Erhöhung der Ag-Dicke auf 21nm wird zwar die Gesamttransmission auf 55% reduziert, das Abstrahlverhältnis jedoch auf 2:1 verbessert.

Die Verwendung einer ITO / Metall / ITO-Elektrode ist nicht in jedem Fall von Vorteil. Eine Deckelektrode mit 5nm ITO / 10nm Ag / 65nm ITO und eine 15nm dicke Ag-Elektrode auf der Substratseite würde zwar die Leitfähigkeit der Elektrode verbessern und trotzdem einen Gesamttransmissionsgrad von 70% erreichen, das Abstrahlverhältnis in beide Richtungen wäre jedoch wieder annähernd gleich. Um das Abstrahlverhältnis bei einer Gesamttransmission von über 50% auf 2:1 zu bringen, müsste die Ag-Dicke auf der Substratseite 20nm betragen.

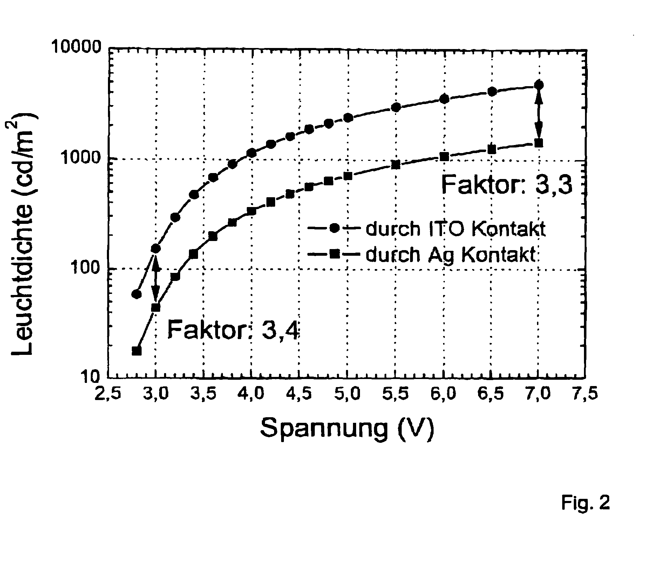

Im folgenden werden unter Bezugnahme auf die Fig. 2 bis 4 weitere Ausführungsbeispiele im Detail erläutert.

Ein organisches lichtemittierendes Bauelement wurde wie folgt hergestellt. Ein mit ITO beschichtetes Glassubstrat wurde zum Ausbilden der Grundelektrode strukturiert und gereinigt. Die Dicke der ITO-Schicht beträgt etwa 130nm bei einem Flächenwiderstand von etwa 20 Ω/∀. Folgende Schichten wurden nacheinander mittels thermischen Verdampfens im Vakuum bei einem Druck von etwa 10⁻⁷mbar aufgebracht, wobei das Vakuum nicht gebrochen wurde:
1) 65nm N,N,N,N'-Tetrakis(4-methoxyphenyl)-benzidine (MeO-TPD) dotiert mit 2,3,5,6-Tetrafluoro-7,7,8,8-tetracyanoquinodimethan (F4-TCNQ) im molekularen Verhältnis von 50:1 als p-dotierte Löcher-Transportschicht;
2) 10nm 2,2',7,7'-Tetrakis-(N,N-diphenylamino)-9-9'-spirobifluoren (Spiro-TAD) als Zwischenschicht;
3) 6nm 4,4',4"-Tris(N-carbazolyl)-triphenylamine (TCTA) dotiert mit 8% fac-Tris(2-phenylpyridine) Iridium (Ir(ppy)₃) bezogen auf die Masse;
4) 12nm 3-Phenyl-4-(18-naphthyl)-5-phenyl-1,2,4-triazole (TAZ) dotiert mit 8% fac-Tris(2-phenylpyridine) Iridium (Ir(ppy)₃) bezogen auf die Masse;
5) 10nm Bathophenanthroline (Bphen) als Zwischenschicht;
6) 50nm Bphen dotiert mit Cs im molekularen Verhältnis von 1:1 als n-dotierte Elektronen-Transportschicht;
7) 15nm Silber als Kathode; und
8) 45nm MeO-TPD als Deckschicht.

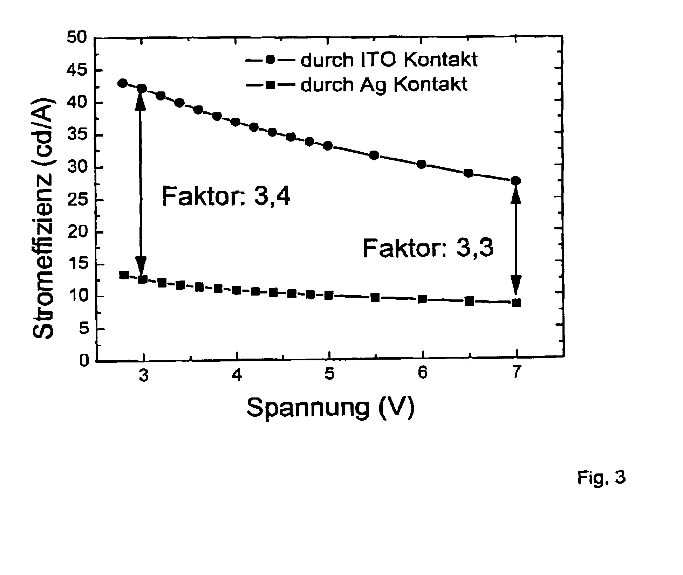

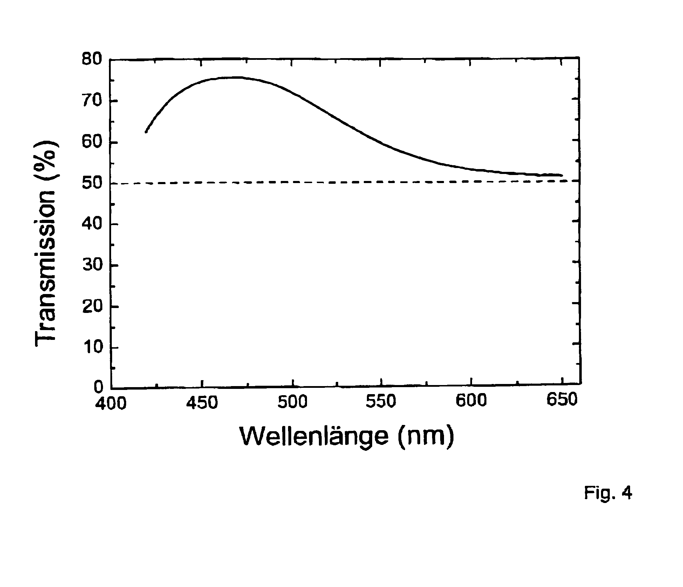

Diese transparente grüne pin-OLED zeigt ein Emissionsmaximum bei etwa 520nm. Bei einer angelegten Spannung von 7V beträgt die Emissionshelligkeit bei Messung durch die ITO-Grundelektrode 4800cd/m2, bei Messung durch den Ag-Deckelektrode hingegen 1400cd/ m². Das entspricht einem Emissionsverhältnis von 3,4 (vgl. Fig. 2) was auch durch das Verhältnis der Stromeffizienz wiedergegeben wird (vgl. Fig. 3). Der Transmissionsgrad dieser Ausführungsform beträgt bis zu etwa 70% im sichtbaren Bereich (vgl. Fig. 4).

Ein weiteres organisches Bauelement wurde wie folgt hergestellt. Ein mit ITO beschichtetes Glassubstrat wurde strukturiert und gereinigt. Die Dicke des ITO beträgt etwa 130nm bei einem Flächenwiderstand von etwa 20Ω/∀. Folgende Schichten wurden nacheinander mittels thermischen Verdampfens im Vakuum bei einem Druck von etwa 10⁻⁷mbar aufgebracht, wobei das Vakuum nicht gebrochen wurde:
1) 40nm N,N,N,N'-Tetrakis(4-methoxyphenyl)-benzidine (MeO-TPD) dotiert mit 2,3,5,6-Tetrafluoro-7,7,8,8-tetracyanoquinodimethan (F4-TCNQ) im molekularen Verhältnis von 50:1 als p-dotierte Löcher-Transportschicht;
2) 10nm N,N'-Di(naphtalen-1-yl)-N,N'-diphenyl-benzidin (α-NPD) als Zwischenschicht;
3) 20nm 2,2',7,7'-Tetrakis-(NN-diphenylamino)-9,9'-spirobifluoren (Spiro-TAD) dotiert mit 20 % Iridium (III) Tris(1-phenylisoquinoline) bezogen auf die Masse;
4) 10nm Bathophenanthroline (Bphen) als Zwischenschicht;
5) 40nm Bphen dotiert mit Cs im molekularen Verhältnis von 1:1 als n-dotierte Elektronentransportschicht; und
6) 15nm Silber als Kathode;

Diese transparente rote pin-OLED zeigt ein Emissionsmaximum bei etwa 620nm. Bei einer angelegten Spannung von 3.4V beträgt die Emissionshelligkeit bei einer Messung durch die ITO-Grundelektrode 1200cd/m², bei der Messung durch die Ag-Deckelektrode hingegen 380cd/m². Das entspricht einem Verhältnis von 3.1. Der optische Transmissionsgrad des Bauelementes beträgt in weiten Teilen des sichtbaren Spektrums zwischen 60% und 70 %.

Mit Hilfe der Erfindung ist es ermöglicht, eine transparente organische Leuchtdiode herzustellen, deren unterschiedliche Abstrahlung auf den beiden Außenseiten nicht auf der Tatsache beruht, dass ein großer Anteil des im lichtemittierenden Bereich erzeugten Lichtes auf seinem Weg durch eine der beiden Elektroden absorbiert wird, was zu einer Verringerung der Effizienz der OLED führen würde. Es wird vielmehr ein Unterschied in der Abstrahlintensität mittels eines erhöhten Reflexionsvermögens der einen Elektrode bei einer gleichzeitig hohen Gesamttransparenz der OLED realisiert.

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Transparentes lichtemittierendes Bauelement mit einer transparenten Schichtanordnung, bei der auf einem transparenten Substrat in einem Stapel flächige Elektroden und ein zwischen den flächigen Elektroden angeordneter organischer Bereich, welcher eine lichtemittierende Schicht umfasst, aus einem oder mehreren organischen Materialien gebildet sind, wobei:
- für zumindest eine Einfallsrichtung ein Transmissionsgrad der transparenten Schichtanordnung für wenigstens einen Wellenlängenteilbereich im sichtbaren Spektralbereich größer als 50% ist,
- eine der flächigen Elektroden eine Oxidschicht aus einem elektrisch leitfähigen Oxidmaterial mit einer Dicke von wenigstens 10nm aufweist und
- in dem organischen Bereich eine oder mehrere dotierte Ladungsträger-Transportschichten gebildet sind,
**dadurch gekennzeichnet, dass** eine andere der flächigen Elektroden, welche in der Schichtanordnung der Elektrode gegenüberliegend angeordnet ist, eine Metallschicht mit einer Dicke von weniger als 40nm aufweist, dass für eine auf einer Seite der transparenten Schichtanordnung austretende Lichtemission und eine auf einer gegenüberliegenden Seite der transparenten Schichtanordnung austretende Lichtemission ein Intensitätsverhältnis von mindestens 2:1 gebildet ist und dass auf der Elektrode und / oder der anderen Elektrode eine Auskoppelschicht aus einem organischen Material zum Lichtauskoppeln gebildet ist.

2. Transparentes lichtemittierendes Bauelement nach Anspruch 1, **dadurch gekennzeichnet, dass** die Elektrode und / oder die andere Elektrode eine mehrschichtige Elektrode ist.

3. Transparentes lichtemittierendes Bauelement nach Anspruch 2, **dadurch gekennzeichnet, dass** die mehrschichtige Elektrode mindestens eine Oxidschicht aus einem elektrisch leitfähigen Oxidmaterial und mindestens eine Metallschicht umfasst.

4. Transparentes lichtemittierendes Bauelement nach Anspruch 2, **dadurch gekennzeichnet, dass** die mehrschichtige Elektrode mehrere Oxidschichten aus jeweils einem elektrisch leitfähigen Oxidmaterial und / oder mehrere Metallschichten umfasst.

5. Transparentes lichtemittierendes Bauelement nach Anspruch 3 oder 4, **dadurch gekennzeichnet, dass** eine oder alle Oxidschichten der mehrschichtigen Elektrode eine Dicke von wenigstens 10nm aufweisen.

6. Transparentes lichtemittierendes Bauelement nach einem der Ansprüche 3 bis 5, **dadurch gekennzeichnet, dass** eine oder alle Metallschichten der mehrschichtigen Elektrode eine Dicke von weniger als 40nm aufweisen.

7. Transparentes lichtemittierendes Bauelement nach einem der vorangehenden Ansprüche, **dadurch gekennzeichnet, dass** die Auskoppelschicht elektrisch leitend ist.

8. Transparentes lichtemittierendes Bauelement nach einem der vorangehenden Ansprüche, **dadurch gekennzeichnet, dass** die Auskoppelschicht einen Brechungsindex von mindestens 1.3 aufweist.

9. Transparentes lichtemittierendes Bauelement nach einem der Ansprüche 1 bis 7, **dadurch gekennzeichnet, dass** die Auskoppelschicht einen Brechungsindex von mindestens 1.6 aufweist.

10. Transparentes lichtemittierendes Bauelement nach einem der vorangehenden Ansprüche, **dadurch gekennzeichnet, dass** auf einer von dem organischen Bereich abgewandten Seite des transparenten Substrats eine Auskopplungsschicht aufgebracht ist.

11. Transparentes lichtemittierendes Bauelement nach Anspruch 10, **dadurch gekennzeichnet, dass** die Auskopplungsschicht mittels einer Auskoppelfolie gebildet ist.

12. Transparentes lichtemittierendes Bauelement nach einem der vorangehenden Ansprüche, **dadurch gekennzeichnet, dass** für die zumindest eine Einfallsrichtung der Transmissionsgrad der transparenten Schichtanordnung für wenigstens einen Wellenlängenteilbereich im sichtbaren Spektralbereich größer als 60% ist.

13. Transparentes lichtemittierendes Bauelement nach einem der Ansprüche 1 bis 11, **dadurch gekennzeichnet, dass** für die zumindest eine Einfallsrichtung der Transmissionsgrad der transparenten Schichtanordnung für wenigstens einen Wellenlängenteilbereich im sichtbaren Spektralbereich größer als 70% ist.

14. Transparentes lichtemittierendes Bauelement nach einem der Ansprüche 1 bis 11, **dadurch gekennzeichnet, dass** für die zumindest eine Einfallsrichtung der Transmissionsgrad der transparenten Schichtanordnung für wenigstens einen Wellenlängenteilbereich im sichtbaren Spektralbereich größer als 80% ist.

15. Transparentes lichtemittierendes Bauelement nach einem der Ansprüche 1 bis 11, **dadurch gekennzeichnet, dass** für die zumindest eine Einfallsrichtung der Transmissionsgrad der transparenten Schichtanordnung für wenigstens einen Wellenlängenteilbereich im sichtbaren Spektralbereich größer als 90% ist.

16. Transparentes lichtemittierendes Bauelement nach einem der vorangehenden Ansprüche, **dadurch gekennzeichnet, dass** für die auf der einen Seite der transparenten Schichtanordnung austretende Lichtemission und die auf der gegenüberliegenden Seite der transparenten Schichtanordnung austretende Lichtemission ein Intensitätsverhältnis von mindestens 3:1 gebildet ist.

17. Transparentes lichtemittierendes Bauelement nach einem der Ansprüche 1 bis 15, **dadurch gekennzeichnet, dass** für die auf der einen Seite der transparenten Schichtanordnung austretende Lichtemission und die auf der gegenüberliegenden Seite der transparenten Schichtanordnung austretende Lichtemission ein Intensitätsverhältnis von mindestens 5:1 gebildet ist.

18. Transparentes lichtemittierendes Bauelement nach einem der Ansprüche 1 bis 15, **dadurch gekennzeichnet, dass** für die auf der einen Seite der transparenten Schichtanordnung austretende Lichtemission und die auf der gegenüberliegenden Seite der transparenten Schichtanordnung austretende Lichtemission ein Intensitätsverhältnis von mindestens 8:1 gebildet ist.

19. Transparentes lichtemittierendes Bauelement nach einem der vorangehenden Ansprüche, **dadurch gekennzeichnet, dass** zwischen dem transparenten Substrat und einer dem transparenten Substrat zugewandten flächigen Elektrode eine zusätzliche Schicht mit einem Brechungsindex von kleiner als 1.4 gebildet ist.

## Claims

1. Transparent light-emitting component having a transparent layer arrangement in which are formed, on a transparent substrate in a stack, planar electrodes and an organic region arranged between the planar electrodes, which organic region comprises a light-emitting layer, made from one or a plurality of organic materials, wherein:
- for at least one direction of incidence, a transmittance of the transparent layer arrangement for at least one wavelength subrange in the visible spectral range is greater than 50%,
- one of the planar electrodes has an oxide layer made from an electrically conductive oxide material having a thickness of at least 10 nm,
- one or a plurality of doped charge carrier transport layers are formed in the organic region,
**characterized in that** another of the planar electrodes, which is arranged opposite to the electrode in the layer arrangement, has a metal layer having a thickness of less than 40 nm, an intensity ratio of at least 2:1 is formed for a light emission emerging on one side of the transparent layer arrangement and a light emission emerging on an opposite side of the transparent layer arrangement, and a coupling-out layer made from an organic material for coupling out light is formed on the electrode and/or the other electrode.

2. Transparent light-emitting component according to Claim 1, **characterized in that** the electrode and/or the other electrode is a multilayer electrode.

3. Transparent light-emitting component according to Claim 2, **characterized in that** the multilayer electrode comprises at least one oxide layer made from an electrically conductive oxide material and at least one metal layer.

4. Transparent light-emitting component according to Claim 2, **characterized in that** the multilayer electrode comprises a plurality of oxide layers made from in each case an electrically conductive oxide material and/or a plurality of metal layers.

5. Transparent light-emitting component according to Claim 3 or 4, **characterized in that** one or all of the oxide layers of the multilayer electrode have a thickness of at least 10 nm.

6. Transparent light-emitting component according to one of Claims 3 to 5, **characterized in that** one or all of the metal layers of the multilayer electrode have a thickness of less than 40 nm.

7. Transparent light-emitting component according to one of the preceding claims, **characterized in that** the coupling-out layer is electrically conductive.

8. Transparent light-emitting component according to one of the preceding claims, **characterized in that** the coupling-out layer has a refractive index of at least 1.3.

9. Transparent light-emitting component according to one of the preceding claims, **characterized in that** the coupling-out layer has a refractive index of at least 1.6.

10. Transparent light-emitting component according to one of the preceding claims, **characterized in that** a coupling-out layer is applied on a side of the transparent substrate which is remote from the organic region.

11. Transparent light-emitting component according to Claim 10, **characterized in that** the coupling-out layer is formed by means of a coupling-out film.

12. Transparent light-emitting component according to one of the preceding claims, **characterized in that**, for the at least one direction of incidence, the transmittance of the transparent layer arrangement for at least one wavelength subrange in the visible spectral range is greater than 60%.

13. Transparent light-emitting component according to one of Claims 1 to 11, **characterized in that** for the at least one direction of incidence, the transmittance of the transparent layer arrangement for at least one wavelength subrange in the visible spectral range is greater than 70%.

14. Transparent light-emitting component according to one of Claims 1 to 11, **characterized in that** for the at least one direction of incidence, the transmittance of the transparent layer arrangement for at least one wavelength subrange in the visible spectral range is greater than 80%.

15. Transparent light-emitting component according to one of Claims 1 to 11, **characterized in that** for the at least one direction of incidence, the transmittance of the transparent layer arrangement for at least one wavelength subrange in the visible spectral range is greater than 90%.

16. Transparent light-emitting component according to one of the preceding claims, **characterized in that** an intensity ratio of at least 3:1 is formed for the light emission emerging on one side of the transparent layer arrangement and the light emission emerging on the opposite side of the transparent layer arrangement.

17. Transparent light-emitting component according to one of Claims 1 to 15, **characterized in that** an intensity ratio of at least 5:1 is formed for the light emission emerging on one side of the transparent layer arrangement and the light emission emerging on the opposite side of the transparent layer arrangement.

18. Transparent light-emitting component according to one of Claims 1 to 15, **characterized in that** an intensity ratio of at least 8:1 is formed for the light emission emerging on one side of the transparent layer arrangement and the light emission emerging on the opposite side of the transparent layer arrangement.

19. Transparent light-emitting component according to one of the preceding claims, **characterized in that** an additional layer having a refractive index of less than 1.4 is formed between the transparent substrate and a planar electrode facing the transparent substrate.

## Revendications

1. Composant transparent émettant de la lumière doté d'un agencement de couche transparent, dans lequel, sur un substrat transparent et dans une pile, des électrodes en deux dimensions et une zone organique, disposée entre les électrodes en deux dimensions, laquelle zone comprend une couche émettant de la lumière, sont formées d'un ou de plusieurs matériaux organiques, sachant que,
- pour au moins un sens d'incidence, un degré de transmission de l'agencement de couche transparent est supérieur à 50 % pour au moins une plage partielle de longueur d'onde dans la plage spectrale visible,
- l'une des électrodes en deux dimensions présente une couche d'oxyde à base d'un matériau d'oxyde électriquement conducteur avec une épaisseur d'au moins 10 nm et
- une ou plusieurs couches de transport dopées de porteur de charge sont formées dans la zone organique,
**caractérisé en ce qu'**une autre des électrodes en deux dimensions, qui est disposée dans l'agencement de couche en face de l'électrode, présente une couche de métal d'une épaisseur de moins de 40 nm, **en ce qu'**un rapport d'intensité d'au moins 2 :1 est formé pour une émission de lumière sortant sur un côté de l'agencement de couche transparent et une émission de lumière sortant sur un côté opposé de l'agencement de couche transparent et **en ce qu'**une couche de découplage à base d'un matériau organique est formée pour le découplage de la lumière sur l'électrode et/ou sur l'autre électrode.

2. Composant transparent émetteur de lumière selon la revendication 1, **caractérisé en ce que** l'électrode et/ou l'autre électrode est une électrode multicouche.

3. Composant transparent émetteur de lumière selon la revendication 2, **caractérisé en ce que** l'électrode multicouche comprend au moins une couche d'oxyde à base d'un matériau d'oxyde électriquement conducteur et au moins une couche de métal.

4. Composant transparent émetteur de lumière selon la revendication 2, **caractérisé en ce que** l'électrode multicouche comprend plusieurs couches d'oxyde à base de respectivement un matériau d'oxyde électriquement conducteur et/ou plusieurs couches de métal.

5. Composant transparent émetteur de lumière selon la revendication 3 ou 4, **caractérisé en ce qu'**une couche d'oxyde ou toutes les couches d'oxyde de l'électrode multicouches présentent une épaisseur d'au moins 10 nm.

6. Composant transparent émetteur de lumière selon l'une des revendications 3 à 5, **caractérisé en ce qu'**une ou toutes les couches de métal de l'électrode multicouches présentent une épaisseur de moins de 40 nm.

7. Composant transparent émetteur de lumière selon l'une des revendications précédentes, **caractérisé en ce que** la couche de découplage est électriquement conductrice.

8. Composant transparent émetteur de lumière selon l'une des revendications précédentes, **caractérisé en ce que** la couche de découplage présente un indice de réfraction d'au moins 1,3.

9. Composant transparent émetteur de lumière selon l'une des revendications 1 à 7, **caractérisé en ce que** la couche de découplage présente un indice de diffraction d'au moins 1,6.

10. Composant transparent émetteur de lumière selon l'une des revendications précédentes, **caractérisé en ce qu'**une couche de découplage est appliquée sur un côté, opposé à la zone organique, du substrat transparent.

11. Composant transparent émetteur de lumière selon la revendication 10, **caractérisé en ce que** la couche de découplage est formée au moyen d'un film de découplage.

12. Composant transparent émetteur de lumière selon l'une des revendications précédentes, **caractérisé en ce que**, pour le au moins un sens d'incidence, le degré de transmission de l'agencement de couche transparent est supérieur à 60% pour au moins une plage de longueur d'onde dans la plage spectrale visible.

13. Composant transparent émetteur de lumière selon l'une des revendications 1 à 11, **caractérisé en ce que**, pour le au moins un sens d'incidence, le degré de transmission de l'agencement de couche transparent est supérieur à 70% pour au moins une plage partielle de longueur d'onde dans la plage spectrale visible.

14. Composant transparent émetteur de lumière selon l'une des revendications 1 à 11, **caractérisé en ce que**, pour le au moins un sens d'incidence, le degré de transmission de l'agencement de couche transparent est supérieur à 80% pour au moins une zone partielle de longueur d'onde dans la plage spectrale visible.

15. Composant transparent émetteur de lumière selon l'une des revendications 1 à 11, **caractérisé en ce que**, pour le au moins un sens d'incidence, le degré de transmission de l'agencement de couche transparent est supérieur à 90% pour au moins une plage partielle de longueur d'onde dans la plage spectrale visible.

16. Composant transparent émetteur de lumière selon l'une des revendications précédentes, **caractérisé en ce que**, pour l'émission de lumière sortant sur l'un des côtés de l'agencement de couche transparent et l'émission de lumière sortant sur le côté opposé de l'agencement de couche transparent, un rapport d'intensité d'au moins 3 :1 est formé.

17. Composant transparent émetteur de lumière selon l'une des revendications 1 à 15, **caractérisé en ce que**, pour l'émission de lumière sortant sur l'un des côtés de l'agencement de couche transparent et l'émission de lumière sortant sur le côté opposé de l'agencement de couche transparent, un rapport d'intensité d'au moins 5 :1 est formé.

18. Composant transparent émetteur de lumière selon l'une des revendications 1 à 15, **caractérisé en ce que**, pour l'émission de lumière sortant sur l'un des côtés de l'agencement de couche transparent et l'émission de lumière sortant sur le côté opposé de l'agencement de couche transparent, un rapport d'intensité d'au moins 8 :1 est formé.

19. Composant transparent émetteur de lumière selon l'une des revendications précédentes, **caractérisé en ce qu'**une couche supplémentaire avec un indice de diffraction inférieur à 1,4 est formée entre le substrat transparent et une électrode en deux dimensions, associée au substrat transparent.
